(19) Europäisches Patentamt
European Patent Office
Office européen des brevets

(11) **EP 4 761 117 A1**

(12) **EUROPEAN PATENT APPLICATION**
published in accordance with Art. 153(4) EPC

(43) Date of publication:
**17.06.2026 Bulletin 2026/25**

(51) International Patent Classification (IPC):
***H03M 1/12*** (2006.01)

(21) Application number: **24915219.0**

(22) Date of filing: **30.12.2024**

(86) International application number:
**PCT/CN2024/143586**

(87) International publication number:
**WO 2025/146005 (10.07.2025 Gazette 2025/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.01.2024 CN 202410006718**

(71) Applicant: **Chipsea Technologies (Shenzhen) Corp.**
**Shenzhen, Guangdong 518000 (CN)**

(72) Inventors:
• **YIN, Wenjie**
**Shenzhen, Guangdong 518000 (CN)**
• **HAO, Weizheng**
**Shenzhen, Guangdong 518000 (CN)**
• **LIU, Weihui**
**Shenzhen, Guangdong 518000 (CN)**

(74) Representative: **Berggren Oy**
**P.O. Box 16**
**Fabianinkatu 21**
**00101 Helsinki (FI)**

(54) **ANALOG-TO-DIGITAL CONVERSION METHOD AND CIRCUIT, CHIP AND ELECTRONIC DEVICE**

(57) The present application provides an analog-to-digital conversion circuit and method, a chip and an electronic device. The analog-to-digital conversion circuit includes: a digital-to-analog conversion capacitor array; a calibration capacitor array for calibrating the digital-to-analog conversion capacitor array; and a logic control module for selecting the digital-to-analog conversion capacitor array and the calibration capacitor array based on a range control signal to sample and/or convert an analog input signal, to reduce or increase the analog input signal according to a ratio corresponding to the range control signal. By multiplexing the calibration capacitor array, a wider range of reduction or increasement of analog input signals can be achieved with a smaller circuit area.

FIG. 1

## Description

This application claims priority to Chinese Patent Application No. 202410006718.5, filed with the Chinese Patent Office on January 2, 2024, titled "analog-to-digital conversion methods and circuits, chips, and electronic devices". The disclosure of the abovementioned application is incorporated herein by reference in its entirety.

## TECHNICAL FIELD

The present application relates to electronic circuit technologies, and in particular to analog-to-digital conversion circuits and methods, chips, and electronic devices.

## BACKGROUND

Before subject to analog-to-digital conversion, an analog input signal, whether bipolar or unipolar, may be expected to be scaled to be within a dynamic range of an analog-to-digital converter (ADC), thereby enabling effective processing of wide-range input signals.

Generally, a resistive divider may be disposed at an analog input of the ADC to scale an analog input signal to be within the dynamic range of the ADC. With this approach, firstly, it is necessary that a source of the analog input signal is able to drive a resistive load; secondly, the resistive divider may consume power from the source of the analog input signal; and thirdly, the range of scaling of the analog input signal is relatively fixed.

Therefore, no effective solution has yet been proposed in the related technologies for scaling the input signal to the dynamic range of the analog-to-digital converter.

## SUMMARY

In view of the above problems, the embodiments of the present application provide analog-to-digital conversion methods and circuits, chips, and electronic devices to solve the above technical problems.

In a first aspect, an analog-to-digital conversion circuit is provided according to some embodiments of the present application. The analog-to-digital conversion circuit includes: a digital-to-analog conversion capacitor array; a calibration capacitor array for calibrating the digital-to-analog conversion capacitor array; and a logic control module for selecting the digital-to-analog conversion capacitor array and the calibration capacitor array based on a range control signal to sample and/or convert an analog input signal, to reduce or increase the analog input signal according to a ratio corresponding to the range control signal.

In a second aspect, a chip including the above an analog-to-digital conversion circuit is provided according to some embodiments of the present application.

In a third aspect, an electronic device is provided according to some embodiments of the present application. The electronic device includes a device body and the above chip disposed in the device body.

In the fourth aspect, an analog-to-digital conversion method is provided according to some embodiments of the present application. The analog-to-digital conversion method includes: selecting, based on a range control signal, a digital-to-analog conversion capacitor array and a calibration capacitor array to sample and/or convert an analog input signal, to reduce or increase the analog input signal according to a ratio corresponding to the range control signal, where the calibration capacitor array is configured to calibrate the digital-to-analog conversion capacitor array.

By utilizing the calibration capacitor array to sample and/or convert the analog input signals, the analog-to-digital conversion methods and circuits, chips, and electronic devices according to the embodiments of the present application can achieve a wider range of reduction or increasement of analog input signals with a smaller circuit area.

These or other aspects of the present application will become more apparent in the following description of the embodiments.

## BRIEF DESCRIPTION OF THE DRAWINGS

To more clearly illustrate the technical solutions in the embodiments or prior art, the accompanying drawings used in the description of the embodiments or prior art will be briefly introduced below. Obviously, the drawings described below are merely some embodiments of the invention. For those skilled in the art, other drawings can be obtained based on these drawings without any creative effort.

FIG. 1 shows a schematic block diagram of an example of an analog-to-digital conversion circuit according to some embodiments of the present application.

FIG. 2a schematically shows a digital-to-analog conversion capacitor array and a calibration capacitor array according to some embodiments of the present application.

FIG. 2b schematically shows an exemplary combination of a digital-to-analog conversion capacitor array and a calibration capacitor array according to some embodiments of the present application.

FIGS. 2c and 2d schematically show equivalents of exemplary combinations of a digital-to-analog conversion capacitor array and a calibration capacitor array according to some embodiments of the present application.

FIG. 3a to 3c schematically show selection of a digital-to-analog conversion capacitor array and a calibration capacitor array to increase analog input signals according to some embodiments of the present application.

FIG. 4 shows a schematic block diagram of another example of an analog-to-digital conversion circuit according to some embodiments of the present application.

FIG. 5 shows a schematic block diagram of yet another example of an analog-to-digital conversion circuit according to some embodiments of the present application.

FIG. 6a to 6d schematically show exemplary combinations of a digital-to-analog conversion capacitor array and a calibration capacitor array according to some embodiments of the present application.

FIG. 7 shows a flowchart of an example of an analog-to-digital conversion method according to some embodiments of the present application.

FIG. 8 shows a flowchart of another example of an analog-to-digital conversion method according to some embodiments of the present application.

## DETAILED DESCRIPTION

The embodiments of the present application are described in detail below. Examples of the embodiments are shown in the accompanying drawings, where the same or similar reference numerals denote the same or similar elements or elements having the same or similar functions throughout. The embodiments described below with reference to the accompanying drawings are exemplary and are only used to illustrate the present application, and should not be construed as limiting the present application.

To enable those skilled in the art to better understand the solutions of the present application, the technical solutions of the embodiments of the present application will be clearly and completely described below with reference to the accompanying drawings. Obviously, the described embodiments are only a part of the embodiments of the present application, and not all of them. All other embodiments obtained by those skilled in the art based on the embodiments of the present application without creative effort are within the scope of protection of the present application.

In the embodiments of the present application, it should be noted that relational terms here such as first and second are used only to distinguish one entity or operation from another entity or operation, and do not necessarily require or imply any such actual relationship or order between these entities or operations.

Furthermore, the terms "comprising", "including" or any other variations thereof are intended to cover non-exclusive inclusion, such that a process, method, article, or apparatus that comprises a list of elements includes not only those elements but also other elements not expressly listed, or elements inherent to such a process, method, article, or apparatus. Without further limitation, an element defined by the phrase "comprising a ..." does not exclude the presence of other identical elements in the process, method, article, or apparatus that includes said element.

In the description of the embodiments of the present application, the words "example" or "for example" are used to indicate exemplification, illustration, or description. Any embodiment or design described as "example" or "for example" in the embodiments of the present application is not to be construed as being more preferred or having more advantages than another embodiment or design. The use of the words "example" or "for example" is intended to present relative concepts in a clear manner.

Furthermore, in the embodiments of the present application, "a plurality of" refers to two or more. Therefore, in the embodiments of the present application, "a plurality of" may also be understood as "at least two". "At least one" may be understood as one or more, such as one, two, or more. For example, including at least one means including one, two, or more, and is not limited to which ones are included. For example, including at least one of A, B or C, then it could include A, B, C, A and B, A and C, B and C, or A and B and C.

It should be noted that in the embodiments of the present application, "and/or" describes the relationship between associated objects, indicating that there may be three relationships. For example, A and/or B may represent: A existing alone, A and B existing simultaneously, or B existing alone. In addition, the character "/", unless otherwise specified, generally indicates that the associated objects before and after it are in an "or" relationship.

It should be noted that in the embodiments of the present application, "connection" may be understood as electrical connection. The connection between two electrical components may be a direct or indirect connection between the two electrical components. For example, the connection between A and B may be a direct connection between A and B, or an indirect connection between A and B through one or more other electrical components.

In the embodiments of the present application, the first terminal/first end of each transistor is one of the source and the drain of the transistor, and the second terminal/second end of each transistor is the other one of the source and the drain of the transistor. Since the source and drain of a transistor may be structurally symmetrical, they may be structurally indistinguishable. That is, the first terminal/first end and the second terminal/second end of the transistor in the embodiments of the present application may be structurally indistinguishable. For example, when the transistor is a P-type transistor, the first terminal/first end is the source of the transistor, and the second terminal/second end is the drain of the transistor. For another example, when the transistor is an N-type transistor, the first terminal/first end is the drain of the transistor, and the second terminal/second end is the source of the transistor.

In the circuit structure provided by the embodiments of the present application, nodes such as the first node and the second node do not represent actual existing components, but rather represent the junction points of related couplings in the circuit diagram. In other words, these nodes are equivalent to the junction points of related couplings in the circuit diagram.

The present application provides analog-to-digital conversion circuits that may achieve a wider range of reduction or increasement of analog input signals with a smaller circuit area.

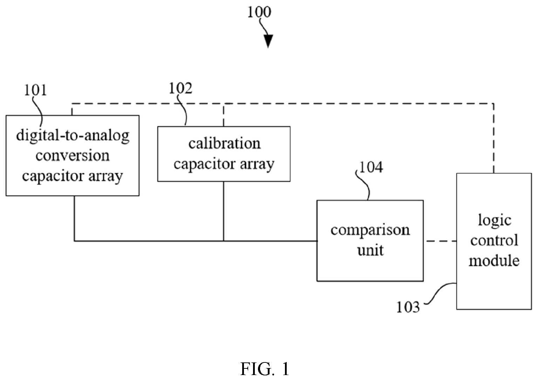

FIG. 1 shows a schematic block diagram of an analog-to-digital conversion circuit according to some embodiments of the present application. As shown in FIG. 1, the analog-to-digital conversion circuit 100 may include a digital-to-analog conversion capacitor array 101, a calibration capacitor array 102, a logic control module 103, and a comparison unit 104. The logic control module 103 may monitor the output of the comparison unit 104. The calibration capacitor array 102 is used to calibrate the digital-to-analog conversion capacitor array 101.

In the embodiments, the logic control module 103 may be configured to select the digital-to-analog conversion capacitor array 101 and the calibration capacitor array 102 based on the range control signal to sample and/or convert the analog input signal, so as to reduce or increase the analog input signal according to the ratio corresponding to the range control signal. For example, to increase or reduce the analog input signal to match the dynamic range of the analog-to-digital conversion circuit 100.

In the embodiments, the logic control module 103 may also be configured to control the calibration capacitor array 102 to perform calibration based on a calibration code. As an implementation, the quantity to be calibrated is the actual capacitance of a capacitor at any capacitor position in the digital-to-analog conversion capacitor array 101. During the calibration phase, the capacitance mismatch value is expressed as an error voltage output by the digital-to-analog conversion capacitor array 101. The calibration capacitor array 102 measures the value of this error voltage and saves the result as the calibration code. During the operation phase, the calibration capacitor array 102 loads the error voltage onto the output of the digital-to-analog conversion capacitor array 101 by connecting different capacitors.

In the embodiments, the smaller the capacitance for sampling the analog input signal, the greater the reduction ratio; the larger the capacitance for sampling the analog input signal, the greater the increasement ratio; and the larger the capacitance for conversion, the greater the reduction ratio. In some examples, the capacitance for sampling may be increased by multiplexing the calibration capacitor array 102 to increase the analog input signal. In some examples, the capacitance for conversion may be increased by multiplexing the calibration capacitor array 102 to reduce the analog input signal. In some examples, the analog input signal may be reduced by decreasing the capacitance for sampling and increasing the capacitance for conversion by multiplexing the calibration capacitor array 102, thereby increasing the reduction ratio of the analog input signal, i.e., reducing the analog input signal to a smaller size. Furthermore, combination of various capacitances for sampling and various capacitances for conversion may provide various reduction or increasement ratios, and more combinations may be achieved by multiplexing the calibration capacitor array 102, providing more reduction or increasement ratios.

In some implementations, the logic control module 103 may: during the conversion phase, select at least one capacitor in the calibration capacitor array 102 to be combined to individual capacitor positions in the digital-to-analog conversion capacitor array 101 based on the range control signal to increase the capacitance of each capacitor position in the digital-to-analog conversion capacitor array 101; and control the combined capacitor positions to perform conversion. This implementation may reduce the analog input signal according to the ratio corresponding to the range control signal.

In one implementation, the logic control module 103 may select the capacitor of at least one capacitor position in the calibration capacitor array 102 based on a range control signal, and combine it with each of capacitors at respective capacitor positions in the digital-to-analog conversion capacitor array. Thus, other unselected capacitor positions in the calibration capacitor array 102 may be used for calibration.

In some embodiments, the logic control module 103 may further: during the sampling phase, select capacitors in the calibration capacitor array 102 and/or the digital-to-analog conversion capacitor array 101 based on the range control signal to sample the analog input signal. In this embodiment, by selecting the capacitance for sampling and the capacitance for conversion based on the range control signal, the analog input signal may be reduced according to the ratio corresponding to the range control signal.

As an example, during the sampling phase, one or more capacitors in the digital-to-analog conversion capacitor array 101 may be selected based on a range control signal to sample the analog input signal. The smaller the capacitance of the selected capacitor, the greater the reduction ratio; that is, the smaller the capacitance for sampling, the smaller the analog-to-digital input signal is reduced. In this example, the calibration capacitor array 102 may be controlled based on a calibration code for calibration during the conversion phase.

As another example, during the sampling phase, one or more capacitors in the calibration capacitor array 102 may be selected based on a range control signal to sample the analog input signal. The smaller the capacitance of the selected capacitor, the greater the reduction ratio; that is, the smaller the capacitance or sampling, the smaller the analog-to-digital input signal is reduced. In this example, the calibration capacitor array 102 may be controlled for calibration based on a calibration code during the conversion phase.

As yet another example, during the sampling phase, one or more capacitors in the digital-to-analog conversion capacitor array 101 and one or more capacitors in the calibration capacitor array 102 may be selected based on a range control signal to sample the analog input signal. The smaller the capacitance of the selected capacitor, the greater the reduction ratio; that is, the smaller the capacitance for sampling, the smaller the analog-to-digital input signal is reduced. In this example, calibration capacitor array 102 may be controlled based on a calibration code for calibration during the conversion phase.

In some implementations, the logic control module 103 may: during the sampling phase, select capacitors in the calibration capacitor array 102 and/or the digital-to-analog conversion capacitor array 101 based on the range control signal to sample the analog input signal; during the conversion phase, select capacitors in the calibration capacitor array 102 and combine them to individual capacitor positions of the digital-to-analog conversion capacitor array 101 based on the range control signal to increase the capacitance of each capacitor position in the digital-to-analog conversion capacitor array 101; and control the combined capacitor positions to perform conversion. In this implementation, the reduction ratio is jointly determined by the capacitance for sampling and the capacitance for conversion, enabling the analog input signal to be reduced according to the ratio corresponding to the range control signal.

In one implementation, the logic control module 103 may: during the conversion phase, connect the capacitor corresponding to the capacitor position of the digital-to-analog conversion capacitor array 101 to a reference voltage terminal, and connect the capacitor combined with it in the calibration capacitor array 102 to the reference voltage terminal; or ground the capacitor corresponding to the capacitor position of the digital-to-analog conversion capacitor array 101, and ground the capacitor combined with it in the calibration capacitor array 102.

As an example, the logic control module 103 may select a capacitor of at least one capacitor position in the calibration capacitor array 102 based on a range control signal, and combine it with the respective capacitor positions in the digital-to-analog conversion capacitor array 101. Exemplarily, each capacitor position in the calibration capacitor array 102 may include multiple capacitors, and a capacitor of at least one capacitor position in the calibration capacitor array 102 may be assigned to each capacitor position of the digital-to-analog conversion capacitor array 101 to adjust the capacitance of each capacitor position in the digital-to-analog conversion capacitor array 101.

For example, taking a binary capacitor array as an example, the capacitance of each capacitor position in the digital-to-analog conversion capacitor array 101 are 8C, 4C, 2C, and 1C, respectively. In the calibration capacitor array 102, one capacitor position includes multiple capacitors, with the capacitances of the capacitors at the highest capacitor position being 4C, 2C, C, and 0.5C, respectively. The capacitors at the highest capacitor position may be combined with the capacitor positions in the digital-to-analog conversion capacitor array 101. After combination, the capacitances of each capacitor position in the digital-to-analog conversion capacitor array 101 are: 12C (i.e., 8C + 4C), 6C (i.e., 4C + 2C), 3C (i.e., 2C + C), and 1.5C (i.e., 1C + 0.5C), in order. In this example, the capacitance ratios between the capacitor positions in the digital-to-analog conversion capacitor array 101 are the same before and after the combination.

In this example, during the conversion phase, if the capacitor corresponding to the highest capacitor position (capacitance of 8C) in the digital-to-analog conversion capacitor array 101 is connected to the reference voltage terminal, and the capacitor with a capacitance of 4C of the highest capacitor position in the calibration capacitor array 102 is connected to the reference voltage terminal, then during the conversion phase, the capacitance of the highest capacitor position increases from 8C to 12C; if the capacitor corresponding to the highest capacitor position (capacitance of 8C) in the digital-to-analog conversion capacitor array 101 is grounded, and the capacitor with a capacitance of 4C at the highest capacitor position in the calibration capacitor array 102 is grounded. Similarly, if the capacitor corresponding to the second highest capacitor position (capacitance of 4C) in the digital-to-analog conversion capacitor array 101 is connected to the reference voltage terminal, and the capacitor with a capacitance of 2C at the highest capacitor position in the calibration capacitor array 102 is connected to the reference voltage terminal, then during the conversion phase, the capacitance of the second highest capacitor position increases from 4C to 6C; if the capacitor corresponding to the second highest capacitor position (capacitance of 4C) in the digital-to-analog conversion capacitor array 101 is grounded, and the capacitor with a capacitance of 2C at the highest capacitor position in the calibration capacitor array 102 is grounded.

In some implementations, the logic control module 103 may also control the unselected capacitor positions in the calibration capacitor array 102 based on the calibration code. For example, the calibration capacitor array 102 includes four calibration capacitor positions. The highest capacitor position of the calibration capacitor array 102 is multiplexed to scale the analog input signal, and the remaining three calibration capacitor positions of the calibration capacitor array 102 may be used for calibration. For example, if the calibration code is 0010, then the remaining three calibration capacitor positions of the calibration capacitor array 102 are controlled based on the last three bits "010" of the calibration code to perform calibration.

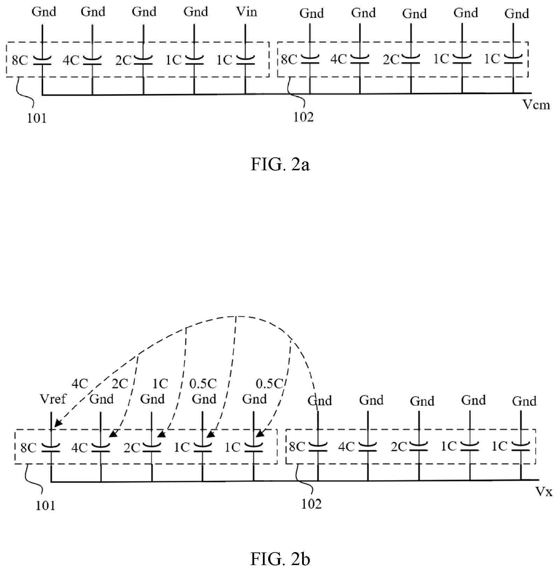

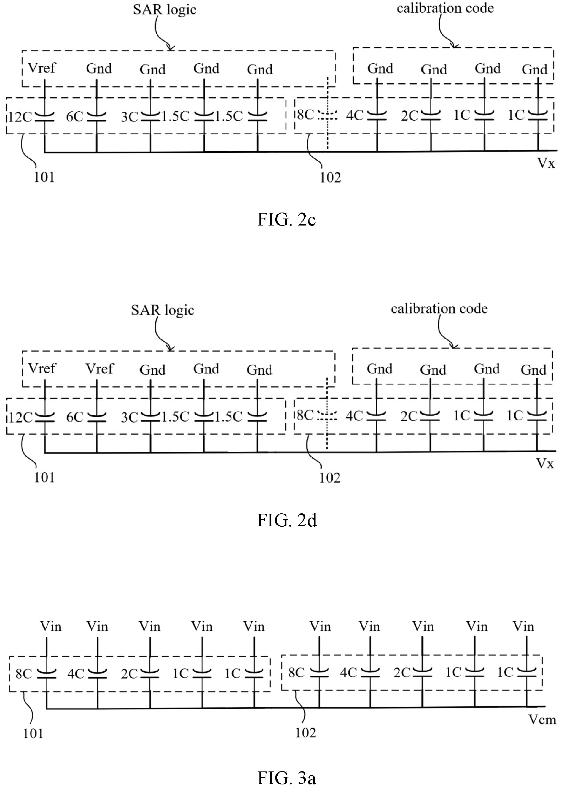

Referring to FIGS. 2a, 2b, 2c, and 2d, an example of reducing an analog input signal is shown. The digital-to-analog conversion capacitor array 101 and the calibration capacitor array 102 each include five capacitor positions, with capacitance of 8C, 4C, 2C, 1C, and 1C, respectively. In this example, the analog input signal is increased by reducing the capacitance for sampling and increasing the capacitance for conversion by multiplexing the calibration capacitor array 102.

During the sampling phase, the logic control module 103 may select a capacitor position with a capacitance of 1C in the digital-to-analog conversion capacitor array 101 to sample the analog input signal. It should be understood that selecting a capacitor position with a capacitance of 1C is merely an example; for instance, capacitor positions with capacitances of 2C, 4C, or 8C may also be selected for sampling the analog input signal. In this example, sampling the analog input signal using a capacitor position with a capacitance of 1C is used for illustration. As shown in FIG. 2a, an end of the digital-to-analog conversion capacitor array 101 connected to the input terminal of the comparison unit 104 receives the common-mode voltage Vcm. The capacitor position with a capacitance of 1C in the digital-to-analog conversion capacitor array 101 receives the analog input signal Vin, and the analog input signal Vin is sampled through this capacitor position; that is, the capacitance for sampling is 1C. An end of the calibration capacitor array 102 connected to the input terminal of the comparison unit 104 may receive the common-mode voltage Vcm, and another end of the calibration capacitor array 102 may be grounded.

After the sampling, the charge magnitude $Q_{21}$ of the digital-to-analog conversion capacitor array 101 and the calibration capacitor array 102 satisfies:

$$Q_{21} = (Vcm - Vin) \times 1C + (Vcm - 0) \times (8C + 4C + 2C + 1C + 8C + 4C + 2C + 1C + 1C)$$
$$= 32C \times Vcm - Vin \times 1C \qquad (1),$$

where Vin represents the analog input voltage and Vcm represents the common-mode voltage.

During the conversion phase, the capacitor position with a capacitance of 8C in the calibration capacitor array 102 may be assigned to the digital-to-analog conversion capacitor array 101. It should be understood that assigning the capacitor position with a capacitance of 8C to the digital-to-analog conversion capacitor array 101 is merely an example; for instance, the capacitor position with a capacitance of 4C in the calibration capacitor array 102 may also be assigned to the digital-to-analog conversion capacitor array 101. As shown in FIG. 2b, according to the capacitance ratio between capacitor positions in the digital-to-analog conversion capacitor array 101, the capacitance of 8C of the capacitor position in the calibration capacitor array 102 are divided into: 4C, 2C, 1C, 0.5C, and 0.5C, which are combined to the capacitor positions in the digital-to-analog conversion capacitor array 101, respectively. As shown in FIG. 2c, after the combination, the equivalent capacitance of each capacitor position in the digital-to-analog conversion capacitor array 102 is 12C (i.e., 8C + 4C), 6C (i.e., 4C + 2C), 3C (i.e., 2C + 1C), 1.5C (i.e., 1C + 0.5C), and 1.5C (i.e., 1C + 0.5C).

During the conversion phase, the logic control module 103 may controls the combined capacitor positions for conversion, specifically controlling the digital-to-analog conversion capacitor array 101 and the capacitor position with the capacitance of 8C in the calibration capacitor array 102. In one embodiment, the remaining capacitor positions in the calibration capacitor array 102 may be controlled based on a calibration code. To facilitate the explanation of the scaling process for the analog input signal, the following are illustrated with grounding the remaining capacitor positions of the calibration capacitor array 102, as an example.

For example, the logic control module 103 may perform successive approximation register (SAR) logic, such as binary search.

In the binary search, as shown in FIG. 2c, the highest capacitor position obtained by combination (capacitance of 12C) is connected to the reference voltage terminal (reference voltage Vref). That is, the capacitor corresponding to the highest capacitor position (capacitance of 8C) in the digital-to-analog conversion capacitor array 101 is connected to the reference voltage terminal, and the capacitor with a capacitance of 4C at the highest capacitor position of the calibration capacitor array 102 is connected to the reference voltage terminal. At this time, the charge magnitude $Q_{22}$ of the digital-to-analog conversion capacitor array 101 and the calibration capacitor array 102 satisfies:

$$Q_{22} = (Vx - Vref) \times 12C + (Vx - 0) \times (6C + 3C + 1.5C + 1.5C) + (Vx - 0) \times (4C + 2C + 1C + 1C)$$
$$= Vx \times 32C - Vref \times 12C \qquad (2),$$

where Vx represents the voltage input to the comparison unit 104 from the digital-to-analog conversion capacitor array 101 and the calibration capacitor array 102, and Vref represents the reference voltage.

According to the law of charge conservation, $Q_{21} = Q_{22}$, therefore:

$$Vx = Vcm - 3/4 \times (1/24 \times Vin - 1/2 \times Vref) \tag{3}.$$

In one implementation, taking the highest capacitor position being "1" as an example, as shown in FIG. 2d, the logic control module 103 connects the combined highest capacitor position to the reference voltage terminal. A binary search is performed, as shown in FIG. 2d, connecting the combined second-highest capacitor position (capacitance of 6C) to the reference voltage terminal. That is, the capacitor corresponding to the second-highest capacitor position (capacitance of 4C) in the digital-to-analog conversion capacitor array 101 is connected to the reference voltage terminal, and the capacitor with a capacitance of 2C at the highest capacitor position in the calibration capacitor array 102 is connected to the reference voltage terminal. At this time, the charge magnitude $Q_{23}$ of the digital-to-analog conversion capacitor array 101 and the calibration capacitor array 102 satisfies:

$$Q_{23} = (Vx - Vref) \times 18C + (Vx - 0) \times (3C + 1.5C + 1.5C) + (Vx - 0) \times (4C + 2C + 1C + 1C)$$
$$= Vx \times 32C - Vref \times 18C \tag{4}.$$

According to the law of charge conservation, $Q_{21} = Q_{23}$, therefore:

$$Vx = Vcm - 3/4 \times (1/24 \times Vin - 1/2 \times Vref - 1/4 \times Vref) \tag{5}.$$

Similarly, during the conversion phase:

$$\mathbf{Vx = Vcm - \frac{3}{4}\left(\frac{1}{24} \times Vin - \sum_{i=0}^{3} \frac{Vref}{2^{4-i}} \times Di\right)} \tag{6},$$

where Di represents the code value of the i-th capacitor position in the digital-to-analog conversion capacitor array 101 controlled by the logic control module 103, with the highest capacitor position i being 3, the second highest capacitor position i being 2, and so on.

Therefore, in the examples shown in FIGS. 2a to 2d, the analog input signal is reduced to 1/24 of its original value.

It should be understood that FIGS. 2a to 2d are merely examples for illustration. In the embodiments of the present application, the scaling ratio may be adjusted by selecting the capacitance for sampling and/or controlling capacitance for conversion. The present application will not elaborate further on this aspect.

In some implementations, the logic control module 103 may, during the sampling phase, select capacitors in the digital-to-analog conversion capacitor array 101 and the calibration capacitor array 102 for sampling based on a range control signal, so as to increase the analog input signal according to the ratio corresponding to the range control signal; and during the conversion phase, it may control each capacitor position of the digital-to-analog conversion capacitor array 101 to perform conversion. In these implementations, the larger the capacitance for sampling, the greater the increasement factor of the analog input signal, and various capacitances for sampling may correspond to various increasement factors. As an implementation, the logic control module 103 may also control the calibration capacitor array 102 based on a calibration code to perform calibration.

As an exemplary illustration, when all capacitor positions in the digital-to-analog conversion capacitor array 101 are used to sample and convert the analog input signal, it may be assumed that the analog input signal is neither reduced nor increased, i.e., the gain is 1. If all capacitor positions in the digital-to-analog conversion capacitor array 101 are used to sample the analog input signal, and capacitors in the calibration capacitor array 102 are selected to sample the analog input signal, the analog input signal may be increased, i.e., the gain is greater than 1. The increasement ratio is positively correlated with the capacitance for sampling.

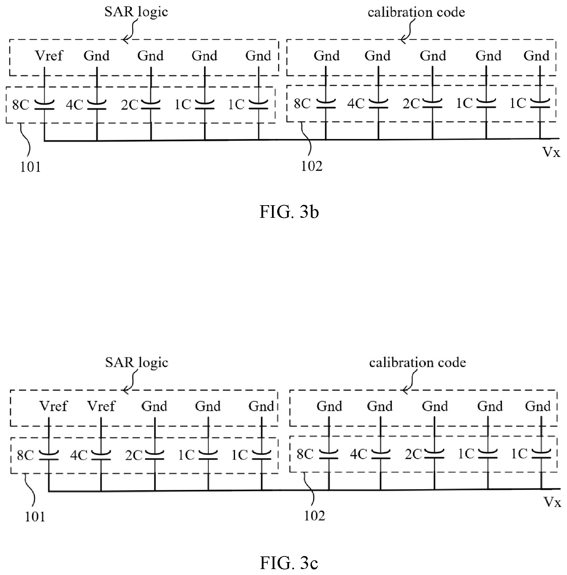

For example, as shown in FIGS. 3a, 3b, and 3c, the digital-to-analog conversion capacitor array 101 includes five capacitor positions each with a capacitance of 8C, 4C, 2C, 1C and 1C, respectively. The calibration capacitor array 102 includes five capacitor positions each with a capacitance of 8C, 4C, 2C, 1C and 1C, respectively.

During the sampling phase, the logic control module 103 may select capacitors from the digital-to-analog conversion capacitor array 101 and the calibration capacitor array 102 to sample the analog input signal Vin. For example, as shown in FIG. 3a, all capacitors in the digital-to-analog conversion capacitor array 101 and the calibration capacitor array 102 are selected to sample the analog input signal Vin, that is, all capacitors receive the analog input signal Vin. At this time, the charge magnitude $Q_{31}$ of the digital-to-analog conversion capacitor array 101 and the calibration capacitor array 102 satisfies:

$$Q_{31} = (Vcm - Vin) \times (8C + 4C + 2C + 1C + 1C + 8C + 4C + 2C + 1C + 1C)$$

$$= (Vcm - Vin) \times 32C \hspace{3cm} (7).$$

During the conversion phase, the logic control module 103 may control the digital-to-analog conversion capacitor array 101 to perform the conversion. For example, the logic control module 103 may perform SAR logic, such as a binary search. In one embodiment, the logic control module 103 may control the calibration capacitor array 102 based on a calibration code during the conversion phase. For ease of illustration regarding scaling of the analog input signal, the following description assumes the calibration capacitor array 102 is grounded (i.e., no calibration is performed).

In the binary search, referring to FIG. 3b, the highest capacitor position in the digital-to-analog conversion capacitor array 101 is connected to the reference voltage, and the remaining capacitor positions are grounded. The calibration capacitor array 102 is grounded (i.e., no calibration is performed). At this time, the charge magnitude $Q_{32}$ of the digital-to-analog conversion capacitor array 101 and the calibration capacitor array 102 satisfy:

$$Q_{32} = (Vx - Vref) \times 8C + (Vx - 0) \times (4C + 2C + 1C + 1C + 8C + 4C + 2C + 1C + 1C)$$

$$= Vx \times 32C - Vref \times 8C \hspace{3cm} (8),$$

where Vx represents the voltage output from the digital-to-analog conversion capacitor array 101 and the calibration capacitor array 102 to the comparison unit 104.

According to the law of charge conservation, $Q_{32} = Q_{31}$, therefore:

$$Vx = Vcm - 1/2(2 \times Vin - 1/2 \times Vref) \hspace{3cm} (9).$$

In one embodiment, taking the highest capacitor position as 1 as an example, as shown in FIG. 3c, the highest and second-highest capacitor positions of the digital-to-analog conversion capacitor array 101 are connected to a reference voltage, while the remaining bits are grounded. The calibration capacitor array 102 is grounded (i.e., no calibration is performed). At this time, the charge magnitude $Q_{33}$ of the digital-to-analog conversion capacitor array 101 and the calibration capacitor array 102 satisfies:

$$Q_{33} = (Vx - Vref) \times (8C + 4C) + (Vx - 0) \times (2C + 1C + 1C + 8C + 4C + 2C + 1C + 1C)$$

$$= Vx \times 32C - Vref \times 12C \hspace{3cm} (10).$$

According to the law of charge conservation, $Q_{33} = Q_{31}$, therefore:

$$Vx = Vcm - 1/2 \times (2 \times Vin - 1/2 \times Vref - 1/4 \times Vref) \hspace{2cm} (11).$$

Similarly, during the conversion phase:

$$\mathbf{Vx = Vcm - \frac{1}{2}\left(2 \times Vin - \sum_{i=0}^{3} \frac{Vref}{2^{4-i}} \times Di\right)} \hspace{2cm} (12),$$

where Di represents the code value of the i-th capacitor position in the digital-to-analog conversion capacitor array 101 controlled by the logic control module 103, with the highest capacitor position i being 3, the second highest capacitor position i being 2, and so on.

Therefore, in the examples shown in FIGS. 3a to 3c, the analog input signal was increased by a factor of 2.

It should be understood that FIGS. 3a to 3c are merely examples for illustration. In this embodiment, the increasement factor of the analog input signal may be adjusted by adjusting the capacitance for sampling the analog input signal in the digital-to-analog conversion capacitor array 101 and the calibration capacitor array 102. For example, for a smaller increasement factor, some capacitor positions in the calibration capacitor array 102 may be selected for sampling, while for a larger increasement factor, more capacitor positions in the calibration capacitor array 102 may be selected for sampling.

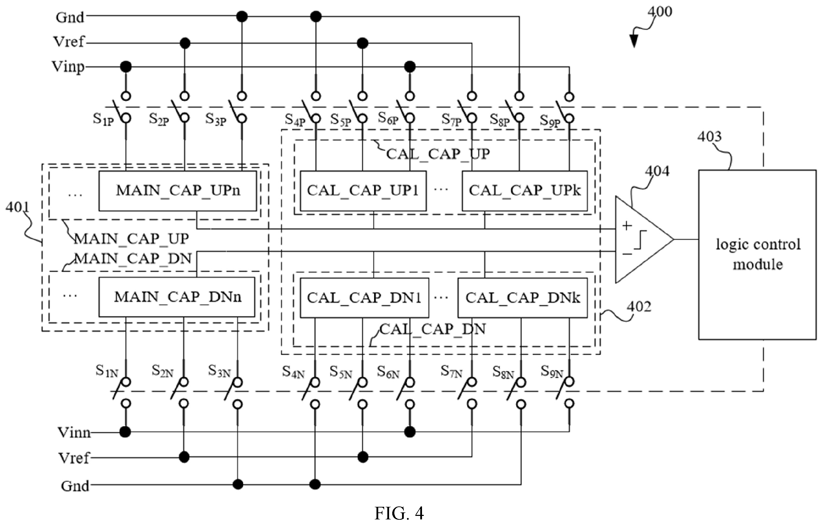

FIG. 4 shows a schematic block diagram of another analog-to-digital conversion circuit according to some embodiments of the present application. As shown in FIG. 4, the analog-to-digital conversion circuit 400 may include a digital-to-analog conversion capacitor array 401, a calibration capacitor array 402, a logic control module 403, and a comparison unit 404. As shown in FIG. 4, the digital-to-analog conversion capacitor array 401 has an output terminal connected to the input terminal of the comparison unit 404. The calibration capacitor array 402 has an output terminal connected to the input terminal of the comparison unit 404. The logic control module 403 may monitor the output of the comparison unit 404. In this embodiment, the analog input signal may be scaled using the digital-to-analog conversion capacitor array 401 and the calibration capacitor array 402, for example, scaling the analog input signal to the dynamic range of the analog-to-digital conversion circuit 400.

For example, as shown in FIG. 4, the digital-to-analog conversion capacitor array 401 may include a positive terminal main capacitor array (referred to as MAIN CAP) MAIN_CAP_UP and a negative terminal main capacitor array MAIN_CAP_DN. The positive terminal main capacitor array MAIN_CAP_UP and the negative terminal main capacitor array MAIN_CAP_DN each include N capacitor positions. For simplicity, only capacitor positions MAIN_CAP_UPn and MAIN_CAP_DNn are shown in FIG. 4. The calibration capacitor array (CAL CAP) 402 may include a positive terminal main capacitor array CAL_CAP_UP and a negative terminal main capacitor array CAL_CAP_DN. The positive terminal main capacitor array CAL_CAP_UP and the negative terminal main capacitor array CAL_CAP_DN each include K capacitor positions, and only capacitor positions CAL_CAP_UP1, CAL_CAP_UPk, CAL_CAP_DN1 and CAL_CAP_DNk are shown in FIG. 4.

For example, as shown in FIG. 4, a switching network (S1P to S9P and S1N to S9N as shown in FIG. 4) is configured to switch capacitor positions or capacitors to receive reference voltage Vref or analog input signals (Vinp, Vinn), or to connect to ground Gnd.

Referring to FIG. 4, when reducing the analog input signal, the logic control module 403 may, during the conversion phase, select at least one capacitor in the calibration capacitor array 402 to be combined to individual capacitor positions in the digital-to-analog conversion capacitor array 401 based on the range control signal to adjust the capacitance of each capacitor position in the digital-to-analog conversion capacitor array 401; and control the combined capacitor positions for conversion. Thus, the calibration capacitor array 402 is multiplexed to reduce the analog input signal, and a large reduction ratio may be achieved with a small circuit area.

When reducing the analog input signal, the logic control module 403 may also select one or more capacitors in the calibration capacitor array 402 and/or the digital-to-analog conversion capacitor array 401 to sample the analog input signal during the sampling phase based on the range control signal. At this time, the reduction ratio of the analog input signal is determined by the capacitance for sampling the analog input signal and the capacitance of each capacitor position after combination. The smaller the capacitance for sampling the analog input signal, the greater the reduction ratio, i.e., the analog input signal is reduced to a smaller size. The larger the capacitance of each capacitor position after combination, the greater the reduction ratio, i.e., the analog input signal is reduced to a smaller size.

As an implementation, when reducing the analog input signal, the logic control module 403 may also control the capacitor positions in the calibration capacitor array 402 that are not combined to the digital-to-analog conversion capacitor array 401 based on the calibration code to perform calibration during the conversion phase. For example, the calibration capacitor array 402 includes four calibration capacitor positions. The highest capacitor position in the calibration capacitor array 402 is multiplexed to reduce the analog input signal, and the remaining three calibration capacitor positions in the calibration capacitor array 402 may be used for calibration. For example, the calibration code is 0010, then the remaining three calibration capacitor positions of the calibration capacitor array 402 are controlled based on the last three bits "010" of the calibration code to perform calibration.

Referring to FIG. 4, when increasing the analog input signal, the logic control module 403 may select capacitors in the digital-to-analog conversion capacitor array 401 and the calibration capacitor array 402 for sampling based on the range control signal during the sampling phase, so as to increase the analog input signal according to the ratio corresponding to the range control signal; and during the conversion phase, it may control each capacitor position of the digital-to-analog conversion capacitor array 401 to perform the conversion. Thus, the calibration capacitor array 402 is multiplexed to increase the analog input signal, and a large increasement factor may be achieved with a small circuit area.

As an implementation, when increasing the analog input signal, the logic control module 403 may also control the calibration capacitor array 402 to perform calibration based on the calibration code during the conversion phase.

Referring to FIG. 4, when not scaling the analog input signal, the logic control module 403 may input the analog input signal into the digital-to-analog conversion capacitor array 401 to sample the analog input signal during the sampling phase; and during the conversion phase, it controls the digital-to-analog conversion capacitor array 401 according to SAR logic to perform the conversion, and controls the calibration capacitor array 402 based on the calibration code. For example, the calibration capacitor array 402 includes 4 calibration capacitor positions, and an exemplary calibration code is 0010. In this case, the third capacitor position of the calibration capacitor array 402 receives the reference voltage Vref and the remaining capacitor positions are grounded for calibration.

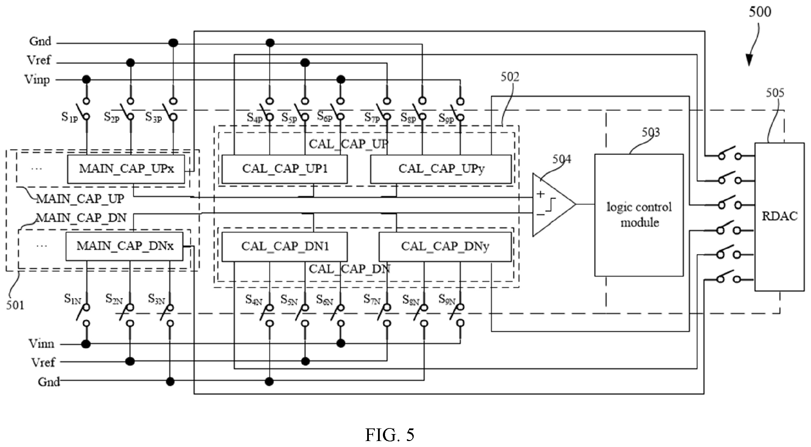

FIG. 5 shows a schematic block diagram of yet another analog-to-digital converter circuit according to some embodiments of the present application. As shown in FIG. 5, the analog-to-digital conversion circuit 500 may include a digital-to-analog conversion capacitor array 501, a calibration capacitor array 502, a logic control module 503, a comparison unit 504, and a resistive digital-to-analog converter (RDAC) 505. The digital-to-analog conversion capacitor array 501 and the RDAC 505 constitute a capacitor-resistor hybrid digital-to-analog converter. The logic control module 503 may monitor the output of the comparison unit 504.

For example, as shown in FIG. 5, the digital-to-analog conversion capacitor array 501 may include a positive terminal main capacitor array (referred to as MAIN CAP) MAIN_CAP_UP and a negative terminal main capacitor array MAIN_CAP_DN. The positive terminal main capacitor array MAIN_CAP_UP and the negative terminal main capacitor array MAIN_CAP_DN each include X capacitor positions. For simplicity, only capacitor positions MAIN_CAP_UPx and MAIN_CAP_DNx are shown in FIG. 5. The calibration capacitor array (CAL CAP) 502 may include a positive terminal main capacitor array CAL_CAP_UP and a negative terminal main capacitor array CAL_CAP_DN. The positive terminal main capacitor array CAL_CAP_UP and the negative terminal main capacitor array CAL_CAP_DN each include Y capacitor positions, and only capacitor positions CAL_CAP_UP1, CAL_CAP_UPy, CAL_CAP_DN1 and CAL_CAP_DNy are shown in FIG. 5.

For example, as shown in FIG. 5, a switching network (S1P to S9P and S1N to S9N as shown in FIG. 5) is configured to switch capacitor positions or capacitors to receive reference voltage Vref or analog-to-digital input signals (Vinp, Vinn), or to connect to ground Gnd.

In this embodiment, the analog input signal may be scaled using the digital-to-analog conversion capacitor array 501 and the calibration capacitor array 502, for example, scaling the analog input signal to the dynamic range of the analog-to-digital conversion circuit 500. The logic control module 503 controls the digital-to-analog conversion capacitor array 501 and the calibration capacitor array 502 to scale the analog input signal, as described above in this specification, and will not be repeated here.

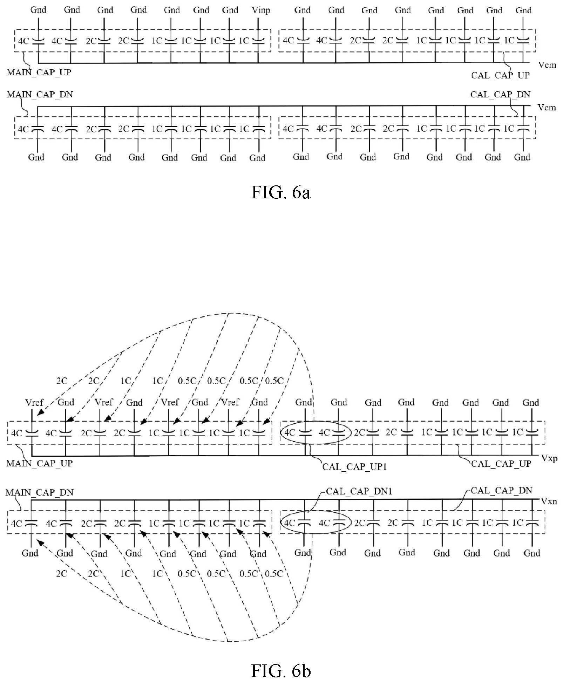

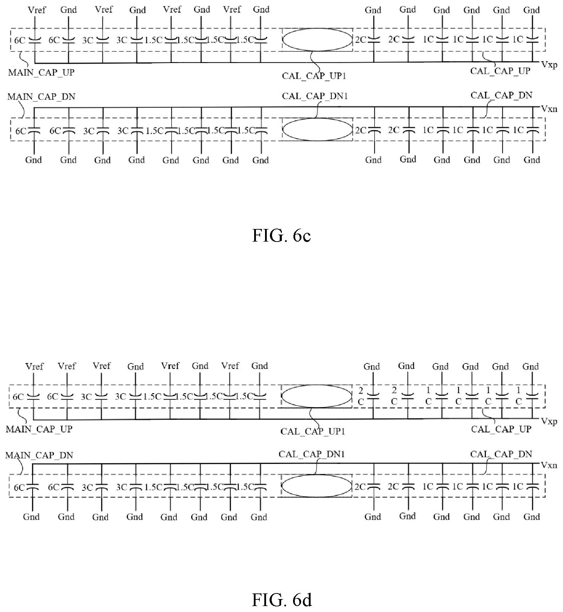

Referring to FIGS. 6a, 6b, 6c and 6d, the main capacitor array and calibration capacitor array in FIG. 4 or FIG. 5 may employ a split capacitor structure. For example, as shown in FIGS. 6a to 6d, each capacitor position may consist of two split capacitor positions. The following explanation uses the reduction of the analog-to-digital input signal as an example.

During the sampling phase, as shown in FIG. 6a, the portion of the main capacitor array with a capacitance of 1C is selected for sampling; that is, the corresponding capacitor receives the analog input signal Vinp, while the remaining capacitors are grounded. At this time, the charge magnitude $Q_{61p}$ in MAIN_CAP_UP and CAL_CAP_UP satisfies:

$$Q_{61p} = (Vcm - Vinp) \times 1C + (Vcm - 0) \times (4C + 4C + 2C + 2C + 1C + 1C + 1C + 4C + 4C + 2C + 2C + 1C + 1C + 1C + 1C) = 32C \times Vcm - Vinp \times 1C \tag{13}$$

During the conversion phase, as shown in FIG. 6b, the capacitor position CAL_CAP_UP1 in the calibration capacitor array is assigned to MAIN_CAP_UP in the main capacitor array, and the capacitor position CAL_CAP_DN1 in the calibration capacitor array is assigned to MAIN_CAP_DN in the main capacitor array, with the allocation ratio shown in FIG. 6b. The equivalent main capacitor array after the allocation may be shown in FIGS. 6c and 6d.

Referring to FIG. 6c, after the combination, a portion of each capacitor position of the main capacitor array is connected to Vref, and the remaining portion of each capacitor position is connected to Gnd. The remaining capacitor positions in the calibration capacitor array CAL_CAP are connected to Gnd (the calibration code is not considered for ease of explanation). At this time, the charge magnitude $Q_{62p}$ in MAIN_CAP_UP and CAL_CAP_UP satisfies:

$$Q_{62p} = (Vxp - Vref) \times (6C + 3c + 1.5C + 1.5C) + (Vxp - 0) \times (6C + 3c + 1.5C + 1.5C) + (Vxp - 0) \times (2C + 2C + 1C + 1C + 1C + 1C) = Vxp \times 32C - Vref \times 12C \tag{14}$$

From $Q_{61p} = Q_{62p}$, it can be obtained that:

$$Vxp = Vcm - \frac{3}{4}(\frac{1}{24} \times Vinp - \frac{1}{2} \times Vref) \tag{15}$$

When the comparison result is smaller, referring to FIG. 6c, the capacitors connected to Vref as shown in FIG. 6c remains unchanged, and the remaining portion of the highest capacitor position, a capacitor of 6C, is connected to Vref. At this time, the charge magnitude $Q_{63p}$ in MAIN_CAP_UP and CAL_CAP_UP satisfies:

$$Q_{63p} = (Vxp - Vref) \times (6C + 6C + 3C + 1.5C + 1.5C) + (Vxp - 0) \times (3c + 1.5C + 1.5C) + (Vxp - 0) \times (2C + 2C + 1C + 1C + 1C + 1C) = Vxp \times 32C - Vref \times 18C \tag{16}$$

From $Q_{61p} = Q_{63p}$, it can be obtained that:

$$Vxp = Vcm - \frac{3}{4}\left(\frac{1}{24} \times Vinp - \frac{1}{2} \times Vref - \frac{1}{4} \times Vref)\right) \tag{17}$$

Following the same logic:

$$Vxp = Vcm - \frac{3}{4}\left(\frac{1}{24} \times Vinp - \sum_{i=0}^{3} \frac{Vref}{2^{4-i}} \times Di\right) \tag{18},$$

where Di represents the code value of the i-th capacitor position, with the highest capacitor position i being 3, the second highest bit i being 2, and so on.

Therefore, by multiplexing the highest capacitor position in the calibration capacitor array during the conversion phase, the analog input signal Vinp is reduced to 1/24 of its original value, and normal conversion may be achieved. When considering the calibration capacitor array having calibration compensation code values during the conversion process, the derivation process is similar as the above, except that the final successive approximation result is not proportional to the previous result because the calibration compensation code value is used for compensating the offset.

The present application also provides an analog-to-digital conversion method, which may be implemented using the analog-to-digital conversion circuit described above. The method includes: selecting a digital-to-analog conversion capacitor array and a calibration capacitor array based on a range control signal to sample and/or convert the analog input signal, so as to reduce or increase the analog input signal according to the ratio corresponding to the range control signal.

In the embodiments of the present application, the smaller the capacitance for sampling the analog input signal, the greater the reduction ratio; the larger the capacitance for sampling the analog input signal, the greater the increasement ratio; and the larger the capacitance for conversion, the greater the reduction ratio. In some examples, the capacitance for sampling may be increased by multiplexing a calibration capacitor array to increase the analog input signal. In some examples, the capacitance for conversion may be increased by multiplexing the calibration capacitor array to reduce the analog input signal. In some examples, the analog input signal may be reduced by decreasing the capacitance for sampling and increasing the capacitance for conversion by multiplexing the calibration capacitor array, thereby increasing the reduction ratio of the analog input signal, i.e., reducing the analog input signal to a smaller size. Furthermore, combinations of various capacitances for sampling and various capacitances for conversion may provide various reduction or increasement ratios, and more combinations may be achieved by multiplexing the calibration capacitor array, providing more reduction or increasement ratios.

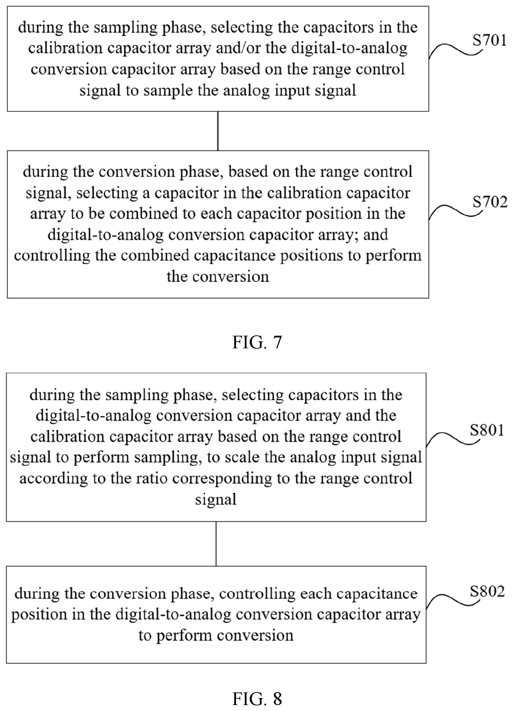

In some implementations, as shown in FIG. 7, the analog-to-digital conversion method includes steps S701 to S702.

In step S701, during the sampling phase, the capacitors in the calibration capacitor array and/or the digital-to-analog conversion capacitor array are selected based on the range control signal to sample the analog input signal.

As an example, during the sampling phase, one or more capacitors in the digital-to-analog conversion capacitor array may be selected based on a range control signal to sample the analog input signal. The smaller the capacitance of the selected capacitor, the greater the reduction ratio; that is, the smaller the capacitance for sampling, the smaller the analog-to-digital input signal is reduced. In this example, during the conversion phase, the calibration capacitor array may be controlled based on a calibration code for calibration.

As another example, during the sampling phase, one or more capacitors in the calibration capacitor array may be selected based on a range control signal to sample the analog input signal. The smaller the capacitance of the selected capacitor, the greater the reduction ratio; that is, the smaller the capacitance for sampling, the smaller the analog-to-digital input signal is reduced. In this example, the calibration capacitor array may be controlled for calibration based on a calibration code during the conversion phase.

As yet another example, during the sampling phase, one or more capacitors in the digital-to-analog conversion capacitor array 101 and one or more capacitors in the calibration capacitor array may be selected based on a range control signal to sample the analog input signal. The smaller the capacitance of the selected capacitor, the greater the reduction ratio; that is, the smaller the capacitance for sampling, the smaller the analog-to-digital input signal is reduced. In this example, the calibration capacitor array may be controlled based on a calibration code for calibration during the conversion phase.

In step S702, during the conversion phase, based on the range control signal, at least one of the capacitors in the calibration capacitor array is selected to be combined to each capacitor position in the digital-to-analog conversion capacitor array to increase the capacitance of each capacitor position in the digital-to-analog conversion capacitor array, and the combined capacitor positions are controlled to perform the conversion.

In one implementation, in step S702, based on the range control signal, the capacitor of at least one capacitor position in the calibration capacitor array is selected and combined to each capacitor position in the digital-to-analog conversion capacitor array. In another implementation, the capacitance ratio between the capacitor positions in the calibration capacitor array after the combination is the same as the capacitance ratio between the capacitor positions before combination.

As an implementation, a calibration may also be performed by controlling the unselected capacitor positions in the calibration capacitor array based on the calibration code.

In some implementations, as shown in FIG. 8, the method may include steps S801 to S802.

In step S801, during the sampling phase, capacitors in the digital-to-analog conversion capacitor array and the calibration capacitor array are selected based on the range control signal to perform sampling, so to scale the analog input signal according to the ratio corresponding to the range control signal.

In step S802, during the conversion phase, each capacitor position in the digital-to-analog conversion capacitor array is controlled to perform conversion.

As an implementation, the calibration capacitor array may also be controlled based on the calibration code.

The present application also provides a chip that includes the analog-to-digital conversion circuit described above. The chip is also called an integrated circuit (IC), and may be, but is not limited to, a System-on-Chip (SoC) chip or a System-in-Package (SIP) chip. This chip may achieve a large range of scaling of analog input signals with a relatively small circuit area.

The present application also provides an electronic device, which includes a device body and a chip as described above disposed within the device body. The electronic device may be, but is not limited to, a weight scale, body fat scale, nutrition scale, infrared electronic thermometer, pulse oximeter, body composition analyser, power bank, wireless charger, fast charger, car charger, adapter, display, universal serial bus (USB) docking station, stylus, true wireless earphones, car infotainment screen, automobile, smart wearable device, mobile terminal, and smart home device. Smart wearable devices include, but are not limited to, smartwatches, smart bracelets, and neck massagers. Mobile terminals include, but are not limited to, smartphones, laptops, tablets, and point of sales terminal (POS) machines. Smart home devices include, but are not limited to, smart sockets, smart rice cookers, smart robot vacuums, and smart lights. This electronic device may achieve a large range of scaling of analog input signals with a relatively small circuit area.

The above are merely some embodiments of the present application and are not intended to limit the present application in any way. Although the present application has disclosed some embodiments as above, it is not intended to limit the present application. Any person skilled in the art can make some modifications or alterations to the above-disclosed technical content to create equivalent embodiments without departing from the scope of the technical solution of the present application. Any simple modifications, equivalent changes and alterations made to the above embodiments based on the technical essence of the present application without departing from the scope of the technical solution of the present application shall still fall within the scope of the technical solution of the present application.

## Claims

1. An analog-to-digital conversion circuit, comprising:

   a digital-to-analog conversion capacitor array;
   a calibration capacitor array for calibrating the digital-to-analog conversion capacitor array; and
   a logic control module for selecting the digital-to-analog conversion capacitor array and the calibration capacitor array based on a range control signal to sample and/or convert an analog input signal, to reduce or increase the analog input signal according to a ratio corresponding to the range control signal.

2. The analog-to-digital conversion circuit according to claim 1, wherein the logic control module is configured to: during a conversion phase,

   select a capacitor in the calibration capacitor array, based on the range control signal, for combination to each of a plurality of capacitor positions in the digital-to-analog conversion capacitor array, to increase a capacitance of the each of the capacitor positions; and
   control the each of the capacitor positions combined with the capacitor in the calibration capacitor array to convert the analog input signal.

3. The analog-to-digital conversion circuit according to claim 2, wherein the logic control module is configured to: select the capacitor corresponding to at least one of a plurality of capacitor positions in the calibration capacitor array, based on the range control signal, for combination to the each of the capacitor positions in the digital-to-analog conversion capacitor array.

4. The analog-to-digital conversion circuit according to claim 3, wherein the logic control module is further configured to control ones of the calibration positions other than the at least one of the calibration positions in the calibration capacitor array based on a calibration code.

5. The analog-to-digital conversion circuit according to claim 2, wherein the logic control module is further configured to, during a sampling phase, select one or more capacitors in the calibration capacitor array and/or one or more capacitors in the digital-to-analog conversion capacitor array based on the range control signal to sample the analog input signal.

6. The analog-to-digital conversion circuit according to claim 2, wherein the logic control module is further configured to: during the conversion phase,

> for any one of capacitors corresponding to the conversion positions in the digital-to-analog conversion capacitor array connected to a reference voltage terminal, connect the capacitor combined to the any one of the capacitors to the reference voltage terminal; and
> for any grounded one of the capacitors corresponding to the conversion positions in the digital-to-analog conversion capacitor array, ground the capacitor combined with the any grounded one of the capacitors.

7. The analog-to-digital conversion circuit according to claim 2, wherein the capacitor positions after the combination have a same capacitance ratio as the capacitor positions before the combination.

8. The analog-to-digital conversion circuit according to claim 1, wherein the logic control module is configured to:

> during a sampling phase, select one or more capacitors in the digital-to-analog conversion capacitor array and one or more capacitors in the calibration capacitor array based on the range control signal to sample the analog input signal, to increase the analog input signal according to the ratio; and
> during a conversion phase, control a plurality of capacitor positions in the digital-to analog conversion capacitor array to convert the analog input signal.

9. The analog-to-digital conversion circuit according to any one of claims 1-8, wherein the logic control module is further configured to control the calibration capacitor array based on a calibration code.

10. A chip, comprising the analog-to-digital conversion circuit according to any one of claims 1-9.

11. An electronic device, comprising:

> a device body; and
> the chip according to claim 10, disposed in the device body.

12. An analog-to-digital conversion method, comprising:

> selecting, based on a range control signal, a digital-to-analog conversion capacitor array and a calibration capacitor array to sample and/or convert an analog input signal, to reduce or increase the analog input signal according to a ratio corresponding to the range control signal,
> wherein the calibration capacitor array is configured to calibrate the digital-to-analog conversion capacitor array.

FIG. 1

FIG. 2a

FIG. 2b

FIG. 2c

FIG. 2d

FIG. 3a

FIG. 3b

FIG. 3c

FIG. 4

EP 4 761 117 A1

18

FIG. 5

FIG. 6a

FIG. 6b

FIG. 6c

FIG. 6d

during the sampling phase, selecting the capacitors in the calibration capacitor array and/or the digital-to-analog conversion capacitor array based on the range control signal to sample the analog input signal ⟶ S701

during the conversion phase, based on the range control signal, selecting a capacitor in the calibration capacitor array to be combined to each capacitor position in the digital-to-analog conversion capacitor array; and controlling the combined capacitance positions to perform the conversion ⟶ S702

FIG. 7

during the sampling phase, selecting capacitors in the digital-to-analog conversion capacitor array and the calibration capacitor array based on the range control signal to perform sampling, to scale the analog input signal according to the ratio corresponding to the range control signal ⟶ S801

during the conversion phase, controlling each capacitance position in the digital-to-analog conversion capacitor array to perform conversion ⟶ S802

FIG. 8

## INTERNATIONAL SEARCH REPORT

| | International application No. |
|---|---|
| | **PCT/CN2024/143586** |

### A. CLASSIFICATION OF SUBJECT MATTER

H03M 1/12(2006.01)i

According to International Patent Classification (IPC) or to both national classification and IPC

### B. FIELDS SEARCHED

Minimum documentation searched (classification system followed by classification symbols)

IPC: H03M

Documentation searched other than minimum documentation to the extent that such documents are included in the fields searched

Electronic data base consulted during the international search (name of data base and, where practicable, search terms used)

CNABS, VEN, USTXT, WOTXT, EPTXT, CNTXT, IEEE, ISI, CNKI: 模数转换, 数模转换, 校准电容, 阵列, 控制, 范围, 比例, 缩放, 采样, 转换, 复用, 共用, 组合, analog-to-digital conversion, digital-to-analog conversion, calibration capacitance, array, control, range, scale, scaling, sampling, converting, multiplexing, sharing, combining

### C. DOCUMENTS CONSIDERED TO BE RELEVANT

| Category* | Citation of document, with indication, where appropriate, of the relevant passages | Relevant to claim No. |
|---|---|---|
| PX | CN 117811582 A (CHIPSEA TECHNOLOGY (SHENZHEN) CO., LTD.) 02 April 2024 (2024-04-02) claims 1-12 | 1-12 |
| A | CN 110690901 A (BEIJING CEC HUADA ELECTRONIC DESIGN CO., LTD.) 14 January 2020 (2020-01-14) description, paragraphs 4-21 | 1-12 |
| A | CN 104079298 A (FUDAN UNIVERSITY) 01 October 2014 (2014-10-01) entire document | 1-12 |
| A | US 7199746 B1 (SILICON LABORATORIES INC.) 03 April 2007 (2007-04-03) entire document | 1-12 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 March 2025** | **13 March 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/143586**

| Patent document cited in search report | | | Publication date (day/month/year) | Patent family member(s) | Publication date (day/month/year) |
|---|---|---|---|---|---|
| CN | 117811582 | A | 02 April 2024 | None | |
| CN | 110690901 | A | 14 January 2020 | None | |
| CN | 104079298 | A | 01 October 2014 | None | |
| US | 7199746 | B1 | 03 April 2007 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410006718